# EUROPEAN PATENT APPLICATION

(11) **EP 4 541 501 A1**
(43) Date of publication of application: **23.04.2025**
(21) Application number: 23842734.8
(22) Date of filing: 20.06.2023
(51) Int. Cl.: B23K 31/00, B33Y 50/00, G01B 11/00, G01B 11/02, G01B 11/24, G01B 11/30

(54) **IMAGE-INFORMATION GENERATING DEVICE AND IMAGE-INFORMATION GENERATING METHOD, IMAGE PROCESSING DEVICE AND IMAGE PROCESSING METHOD, DEFECT PREDICTING DEVICE AND DEFECT PREDICTING METHOD, AND PROGRAM**

(30) Priority: 20.07.2022 JP 2022115682
(71) Applicant: KABUSHIKI KAISHA KOBE SEIKO SHO (KOBE STEEL, LTD.), Hyogo 651-8585 (JP)
(72) Inventor: HUANG, Shuo, Nishi-ku, Kobe-shi, Hyogo 651-2271 (JP)
(74) Representative: Müller-Boré & Partner Patentanwälte PartG mbB
(86) International application number: PCT/JP2023/022825
(87) International publication number: WO 2024/018803

(57) **Abstract**

An image information generating device generates image information representing a shape of a manufactured object obtained by depositing layers each made of a plurality of welding beads. The image information generating device includes: a coordinate information acquisition unit configured to approximate a design shape of each layer of the manufactured object using a model simulating a shape of the welding bead and acquire coordinate information on a plurality of points of the approximated model; a profile extraction unit configured to obtain a profile representing a surface shape of the specified layer based on the coordinate information; and an image information conversion unit configured to convert a concave-convex shape of a surface of the specified layer into image information using the profile.

## Description

### TECHNICAL FIELD

The present invention relates to an image information generating device and an image information generating method, an image processing device and an image processing method, a defect predicting device and a defect predicting method, and a program.

### BACKGROUND ART

In arc welding, a technique for detecting a defect occurring in a weld structure and determining whether appropriate welding is performed is known. For example, Patent Literature 1 discloses a technique for determining a quality of welding by acquiring a plurality of pieces of information related to a behavior of a welder, a shape of a molten pool, a wire extension length, and the like during semi-automatic welding (Patent Literature 1).

### CITATION LIST

### PATENT LITERATURE

Patent Literature 1: JP2008-110388A

### SUMMARY OF INVENTION

### TECHNICAL PROBLEM

In additive manufacturing in which a manufactured object is obtained by depositing welding beads with the above-described arc welding, when welding conditions or bead formation paths are inappropriate, a narrow portion may be generated between the beads. When the building is continued while the narrow portion is generated, a welding defect which is a melting defect (unweld) may be generated at a position of the narrow portion. Therefore, it is important to select a welding condition or a bead formation path that does not cause a welding defect after predicting in advance the unevenness of a shape to be deposited and a possibility of occurrence of a defect.

However, in the additive manufacturing, the number of paths and a path length tend to increase as compared with normal welding, and it is difficult to predict a shape of the manufactured object before being built and optimize the welding conditions or the like. As the shape of the manufactured object becomes complicated, the processing of the prediction and the optimization becomes complicated.

Therefore, an object of the present invention is to provide an image information generating device and an image information generating method, an image processing device and an image processing method, a defect predicting device and a defect predicting method, and a program that make it easy to visually grasp information on a distribution of unevenness, excess or shortage of an additive height, and the like even for a manufactured object having a complicated shape and being less likely to be grasped.

### SOLUTION TO PROBLEM

The present invention has the following configurations.
(1) An image information generating device that generates image information representing a shape of a manufactured object obtained by depositing layers each made of a plurality of welding beads, the image information generating device including:
   a coordinate information acquisition unit configured to approximate a design shape of each layer of the manufactured object using a model simulating a shape of the welding bead and acquire coordinate information on a plurality of points of the approximated model;
   a profile extraction unit configured to obtain a profile representing a surface shape of the specified layer based on the coordinate information; and
   an image information conversion unit configured to convert a concave-convex shape of a surface of the specified layer into image information using the profile.
(2) An image processing device including:
   a narrow portion extraction unit configured to extract a concave narrow portion formed by the welding beads through image processing from the image information generated by the image information generating device according to (1); and
   a feature calculation unit configured to calculate a feature including any one of a position and a size of the extracted narrow portion.
(3) A defect predicting device including:
   the image information generating device according to (1);
   a narrow portion extraction unit configured to extract a concave narrow portion formed by the welding beads through image processing from the image information generated by the image information generating device;
   a feature calculation unit configured to calculate a feature including any one of a position and a size of the extracted narrow portion;
   an additive condition acquisition unit configured to acquire an additive condition of the welding beads that form the narrow portion; and
   a defect determination unit configured to predict presence or absence of a defect occurring in the narrow portion in the manufactured object or a size of the defect according to the feature of the narrow portion and the additive condition of the narrow portion.
(4) An image information generating method for generating image information representing a shape of a manufactured object obtained by depositing layers each made of a plurality of welding beads, the image information generating method including:
   approximating a design shape of each layer of the manufactured object using a model simulating a shape of the welding bead and acquiring coordinate information on a plurality of points of the approximated model;
   obtaining a profile representing a surface shape of the specified layer based on the coordinate information; and
   converting a concave-convex shape of a surface of the specified layer into image information using the profile.
(5) An image processing method including:
   extracting a concave narrow portion formed by the welding beads through image processing from the image information generated by using the image information generating method according to (4); and
   calculating a feature including any one of a position and a size of the extracted narrow portion.
(6) A defect predicting method including:
   extracting a concave narrow portion formed by the welding beads through image processing from the image information generated by using the image information generating method according to (4);
   calculating a feature including any one of a position and a size of the extracted narrow portion;
   acquiring an additive condition of the welding beads that form the narrow portion; and
   predicting presence or absence of a defect occurring in the narrow portion in the manufactured object or a size of the defect according to the feature of the narrow portion and the additive condition of the narrow portion.
(7) A program for executing a procedure for generating image information representing a shape of a manufactured object obtained by depositing layers each made of a plurality of welding beads, the program causing a computer to execute:
   a procedure of approximating a design shape of each layer of the manufactured object using a model simulating a shape of the welding bead and acquiring coordinate information on a plurality of points of the approximated model;
   a procedure of obtaining a profile representing a surface shape of the specified layer based on the coordinate information; and
   a procedure of converting a concave-convex shape of a surface of the specified layer into image information using the profile.

### ADVANTAGEOUS EFFECTS OF INVENTION

According to the present invention, it is possible to obtain image information that makes it easy to visually grasp information on a distribution of unevenness, excess or shortage of an additive height, and the like even for a manufactured object having a complicated shape and being less likely to be grasped. Accordingly, the defect size can be accurately predicted, and the occurrence of defects can be prevented.

### BRIEF DESCRIPTION OF DRAWINGS

FIG. 1 is an overall configuration diagram of a welding system.
FIG. 2 is a block diagram of a defect predicting device.
FIG. 3 is a flowchart illustrating a procedure of a defect predicting method performed by the defect predicting device.
FIG. 4 is a diagram illustrating a state in which a shape of a manufactured object is reproduced by a plurality of unit models.
FIG. 5 is a diagram illustrating a point group of vertices of the unit models.
FIG. 6 is a diagram illustrating one row of unit models extending in a depth direction.
FIG. 7 is a diagram illustrating a state in which a shape of a manufactured object is reproduced by elliptical unit models.
FIG. 8A is a diagram illustrating a state in which a profile is extracted from a plurality of unit models approximate to the shape of the manufactured object.
FIG. 8B is a diagram illustrating the state in which the profile is extracted from the plurality of unit models approximate to the shape of the manufactured object.
FIG. 9A is a schematic diagram of an image based on image information expressed in a contour form.
FIG. 9B is a graph illustrating pixel values on a line IX-IX in FIG. 9A.
FIG. 10 is a diagram illustrating a case in which welding beads B are built on an inclined base.
FIG. 11 is a diagram illustrating an example of features of a narrow portion.
FIG. 12 is a functional block diagram of a defect determination unit provided in the defect predicting device.
FIG. 13 is a model diagram illustrating contents of an additive plan for a manufactured object formed by a plurality of welding beads.
FIG. 14 is a graph illustrating a height distribution of the model in a cross section taken along a line XIV-XIV in FIG. 13.
FIG. 15 is an image illustrating results of imaging information on a point group extracted from the model diagram of FIG. 13.
FIG. 16 is an image illustrating results of processing the image illustrated in FIG. 15 to highlight narrow portions.

### DESCRIPTION OF EMBODIMENTS

Hereinafter, configuration examples of the present invention will be described in detail with reference to the drawings. Here, an example of an additive manufacturing device for manufacturing a manufactured object by depositing welding beads with arc welding will be described, and a method for manufacturing a manufactured object and a device configuration for additive manufacturing are not limited thereto.

### <Configuration of Additive Manufacturing Device>

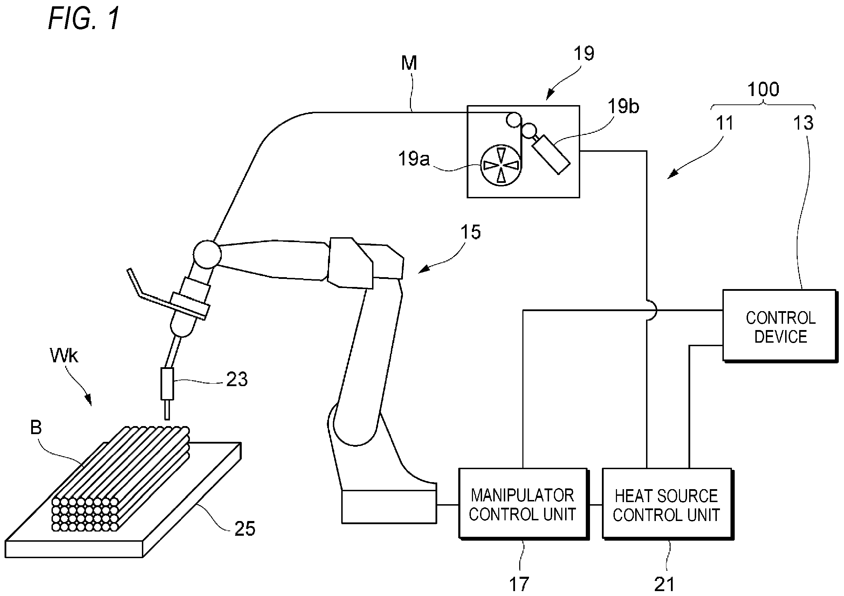

FIG. 1 is an overall configuration diagram of an additive manufacturing device. The additive manufacturing device 100 includes a manufacturing unit 11 and a control device 13. The manufacturing unit 11 includes a manipulator 15, a manipulator control unit 17, a filler metal supply unit 19, and a heat source control unit 21.

The manipulator control unit 17 controls the manipulator 15 and the heat source control unit 21. A controller (not illustrated) is connected to the manipulator control unit 17, and an operator can instruct any operation of the manipulator control unit 17 via the controller.

The manipulator 15 is, for example, an articulated robot, and a filler metal M is supported by a welding torch 23 provided on a tip end shaft of the manipulator 15 so as to be continuously supplied. The welding torch 23 holds the filler metal (also referred to as a welding wire) M in a state of protruding from a tip end thereof. A position and posture of the welding torch 23 can be freely set three-dimensionally within a range of degrees of freedom of a robot arm constituting the manipulator 15. The manipulator 15 preferably has six or more degrees of freedom, and is preferably capable of freely changing an axial direction of a heat source at a tip end thereof. The manipulator 15 may be in various forms, such as an articulated robot having four or more axes illustrated in FIG. 1 or a robot having angle adjustment mechanisms on two or more orthogonal axes.

The welding torch 23 includes a shield nozzle (not illustrated), and is supplied with shield gas from the shield nozzle. The shield gas blocks the atmosphere, prevents oxidation, nitridation, and the like of molten metal during welding, and reduces welding failures. An arc welding method used in this configuration may be any one of a consumable electrode type such as coated arc welding or carbon dioxide gas arc welding, and a non-consumable electrode type such as the Tungsten Inert Gas (TIG) welding or plasma arc welding, and is appropriately selected depending on an object to be built. Here, gas metal arc welding will be described as an example. In the case of the consumable electrode type, a contact tip is disposed inside the shield nozzle, and the filler metal M to which a current is supplied is held by the contact tip. The welding torch 23 generates an arc from a tip end of the filler metal M in a shield gas atmosphere while holding the filler metal M.

The filler metal supply unit 19 supplies the filler metal M toward the welding torch 23. The filler metal supply unit 19 includes a reel 19a around which the filler metal M is wound, and a feeding mechanism 19b that feeds the filler metal M from the reel 19a. The filler metal M is fed to the welding torch 23 while being fed forward or backward by the feeding mechanism 19b as necessary. The feeding mechanism 19b is not limited to a push type disposed on a filler metal supply unit 19 side to push out the filler metal M, and may be a pull type or a push-pull type disposed on the robot arm or the like.

The heat source control unit 21 is a welding power source that supplies electric power required for welding by the manipulator 15. The heat source control unit 21 adjusts a welding current and a welding voltage to be supplied at the time of forming beads by melting and solidifying the filler metal M. In addition, a filler metal feeding speed of the filler metal supply unit 19 is adjusted in conjunction with welding conditions such as the welding current and the welding voltage set by the heat source control unit 21.

A heat source for melting the filler metal M is not limited to the above-described arc. For example, a heat source using another method such as a heating method using both an arc and a laser, a heating method using plasma, or a heating method using an electron beam or a laser may be used. In the case of heating by an electron beam or a laser, a heating amount can be more finely controlled, and a state of a bead to be formed can be more appropriately maintained, thereby contributing to further improvement in quality of an additive structure. In addition, a material of the filler metal M is not particularly limited, and for example, types of the filler metal M to be used may be different according to properties of a manufactured object Wk such as mild steel, high-tensile steel, aluminum, aluminum alloy, nickel, and nickel-base alloy.

The control device 13 collectively controls the above-described units. The control device 13 is implemented by hardware using an information processing device such as a personal computer (PC).

The additive manufacturing device 100 having the above-described configuration operates according to a manufacturing program created based on an additive plan of the manufactured object Wk. The manufacturing program includes a large number of command codes, and is created based on an appropriate algorithm according to various conditions such as a shape, a material, and a heat input amount of the manufactured object Wk. When the filler metal M to be fed is melted and solidified while moving the welding torch 23 according to the manufacturing program, linear welding beads B which are molten and solidified bodies of the filler metal M are formed on a base 25. That is, the manipulator control unit 17 drives the manipulator 15 and the heat source control unit 21 based on a predetermined manufacturing program provided from the control device 13. The manipulator 15 forms the welding beads B by moving the welding torch 23 while melting the filler metal M with an arc, according to a command from the manipulator control unit 17. By sequentially forming and depositing the welding beads B in this manner, the manufactured object Wk having a desired shape can be obtained.

Next, an additive plan of the manufactured object to be built by the additive manufacturing device 100 will be described.

The additive plan is determined based on a predetermined algorithm according to conditions such as the shape of the manufactured object to be built and the specifications of each unit constituting the additive manufacturing device 100. Specifically, the additive plan includes information on a trajectory (path) along which the welding torch 23 is moved, information on welding conditions for forming a welding bead, and the like. A specific procedure for determining the additive plan is known, and thus the description thereof is omitted here.

As the shape of the manufactured object becomes complicated, it becomes difficult to grasp contents of the additive plan. Therefore, it is preferred that the additive plan is represented by image information and the image information can be displayed on a display unit such as a monitor. In this case, it is easy for a worker to visually confirm the contents of the additive plan or extract and evaluate a part serving as a feature. That is, if the additive plan can be visualized, it is easy to extract a factor causing various defects such as an unweld defect, and it is also possible to predict a defect based on information on the extracted defect factor. Examples of the defect factor include a narrow portion formed by welding beads. It is known that an unweld welding bead is likely to occur in the narrow portion. Here, the presence or absence of a defect or a size of the defect is predicted based on information on the narrow portion. In the following description, the narrow portion is described as the defect factor, the present invention is not limited thereto, and other factors may be extracted to predict a defect.

Next, a defect predicting method and a defect predicting device for predicting information on a defect in the narrow portion in the manufactured object based on an additive plan will be described in detail below.

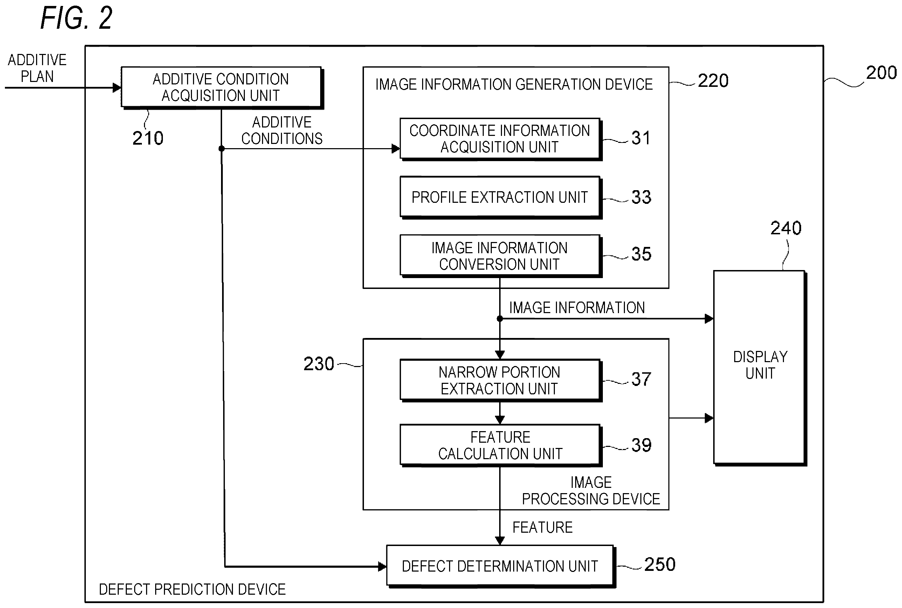

FIG. 2 is a block diagram of a defect predicting device 200.

The defect predicting device 200 includes an additive condition acquisition unit 210 that acquires additive conditions based on a prepared additive plan, an image information generating device 220, an image processing device 230, and a defect determination unit 250.

The image information generating device 220 represents a design shape of each layer of the manufactured object based on the additive plan by a model simulating a bead shape of a welding bead, and generates image information representing a surface shape of a specified layer based on coordinate information on a plurality of points of the model. The specification of a layer can be freely set by a user of the defect predicting device. The image information generating device 220 includes a coordinate information acquisition unit 31, a profile extraction unit 33, and an image information conversion unit 35, the details of which will be described later. The coordinate information acquisition unit 31 approximates the design shape of each layer of the manufactured object using the model simulating the shape of the welding bead, and acquires coordinate information on a plurality of points of the approximated model. The profile extraction unit 33 obtains a profile representing the surface shape of the specified layer based on the acquired coordinate information. The image information conversion unit 35 converts a concave-convex shape of a surface of the specified layer into image information using the obtained profile.

The image processing device 230 includes a narrow portion extraction unit 37 that performs image processing on the image information generated by the image information generating device 220 and extracts a concave narrow portion formed by welding beads, and a feature calculation unit 39 that calculates a feature including any one of a position and a size of the extracted narrow portion based on the image information.

The defect predicting device 200 may include a display unit 240 that displays the image information output from the image information generating device 220 and the information on the feature output from the image processing device 230. By displaying the respective output information on the display unit 240, the set additive conditions are likely to be visually grasped.

The defect predicting device 200 further includes the defect determination unit 250 that predicts the presence or absence of a defect such as an unweld defect in the narrow portion in the manufactured object or a size of the defect according to the feature of the narrow portion calculated by the feature calculation unit 39 and the additive conditions of the narrow portion.

Similar to the control device 13, the defect predicting device 200 is implemented by hardware using the information processing device such as a personal computer (PC). A control function of the defect predicting device 200 is implemented by a control device (not illustrated) reading and executing a program having a specific function stored in a storage device. Examples of the control device include a processor such as a central processing unit (CPU) and a micro processor unit (MPU), or a dedicated circuit. Examples of the storage device include a memory such as random access memory (RAM) and read only memory (ROM), and a storage such as hard disk drive (HDD) and solid state drive (SSD). The defect predicting device 200 may include the above-described components such as the image information generating device 220 and the image processing device 230, or may remotely connect the components via a network or the like. The image processing device 230 may have a configuration suitable for high-speed processing, including a graphics processing unit (GPU) in a processor.

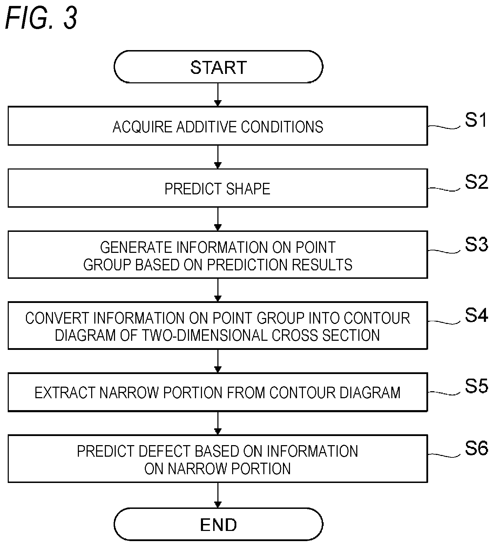

FIG. 3 is a flowchart illustrating a procedure of the defect predicting method performed by the defect predicting device. Hereinafter, a procedure for predicting a defect by the defect predicting device 200 will be described.

First, the additive condition acquisition unit 210 acquires information on an additive plan, which is control information related to the depositing of welding beads when a manufactured object is additively manufactured (S1). For example, various additive conditions necessary for prediction are extracted from the prepared additive plan of the manufactured object. The necessary additive conditions include information related to a movement trajectory of the welding torch, information related to a torch posture at the time of movement, and the like. The information related to the movement trajectory includes, for example, three-dimensional coordinates (x, y, z) of a specific point P located on a trajectory (manufacturing path). The information related to the torch posture includes, for example, angles (α, β, γ) around the respective coordinate axes. The coordinate information and the information related to the torch posture are not limited to the above-described examples, and may be, for example, information on a cylindrical coordinate system (r, θ, z) represented by using pole coordinates, and the torch posture may be determined based on each joint angle or joint position of the manipulator holding the torch. In addition, a welding current, a welding voltage, a feeding speed of a welding wire, a pattern of a movement trajectory (presence or absence of weaving), an inter-path time from the end of a specific manufacturing path to the start of a next path, and the like may be included. The coordinate information is extracted from the input additive conditions by the coordinate information acquisition unit 31 of the image information generating device 220.

Next, a shape of the manufactured object is predicted based on the obtained additive conditions (S2). Here, a profile in which a deposited shape when a plurality of welding beads are deposited is represented by models simulating a bead shape of the welding beads is obtained.

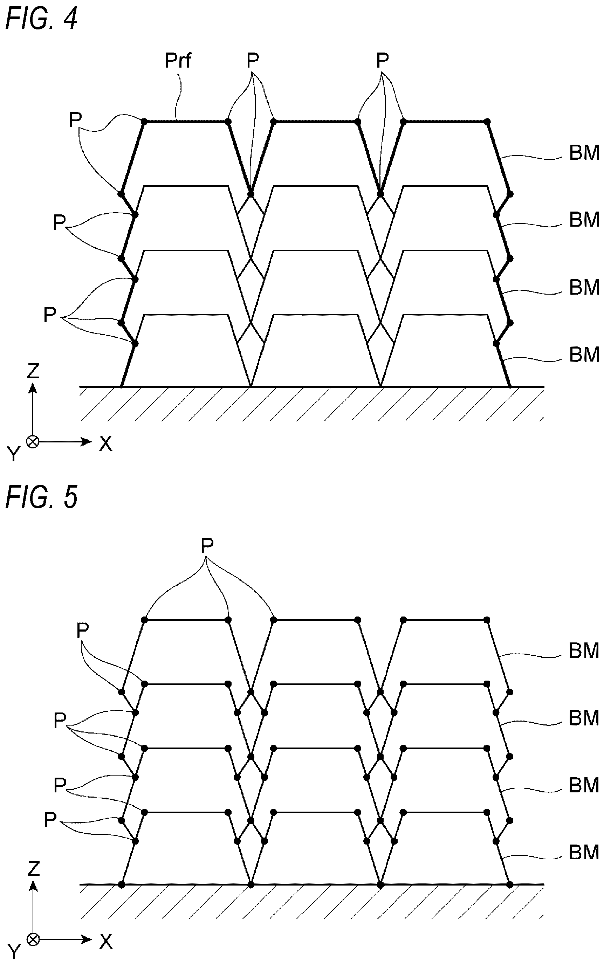

FIG. 4 is a diagram illustrating a state in which the shape of the manufactured object is reproduced by a plurality of unit models BM. A profile Prf of a deposited shape is preferably predicted using the unit models BM each having a shape that simulates the bead shape. By using the unit models BM, the shape can be simplified, and the calculation of coordinate values or the like can be reduced. Specifically, the unit models BM representing the bead shape are arranged in a plurality of rows and a plurality of layers along the manufacturing path to approximate the shape of the manufactured object to be built. The shape of the unit model BM itself changes according to welding conditions (welding current, welding voltage, feeding speed of welding wire, travel speed, and the like). Furthermore, it is desirable that each unit model BM reflects, in the model shape, the overlap of adjacent beads, the dripping of beads, and the like according to the arrangement state. The shape of the unit model BM may be various shapes such as a trapezoid or a shape close to a trapezoid, a polygonal shape, and an elliptical shape, and is not particularly limited.

The plurality of unit models BM arranged in this manner reproduce the deposited shape of the manufactured object by applying information on the welding conditions, target positions for bead formation, and the like. A shape of a model outer surface formed by overlapping the unit models BM can be grasped based on the deposited shape reproduced by the plurality of unit models BM. The shape is represented as the profile Prf connecting outermost edges of the unit models BM as illustrated in FIG. 4. The profile Prf is extracted by the profile extraction unit 33 illustrated in FIG. 2. The profile Prf of the model outer surface may be extracted for each manufacturing path or for each layer. That is, if the profile Prf representing a deposited shape in any layer is extracted at any timing during the building, the deposited shape in the layer at the timing can be predicted freely.

Next, information on a three-dimensional point group is generated based on information on the profile Prf representing a shape of a model outer surface of a specified layer (S3). When an original outer surface is formed by bending a straight line as illustrated in FIG. 4, a plurality of points P which are corner portions of each straight line may be set as a point group. Vertices in the shape of each unit model BM may be set as a point group.

FIG. 5 is a diagram illustrating a point group of vertices of the unit models. As illustrated in FIG. 5, the points P at the vertices of the unit models BM with a triangle added to trapezoids or bases of trapezoids are made into information on the point group. For example, vertices of the unit models BM on a first layer can be defined as a point group of the first layer. In a case of the unit models BM on a second layer, vertices exposed to an outside of the unit models on the second layer and vertices of the unit models on the first layer exposed to the outside from the unit models on the second layer can be defined as a point group of the second layer.

The information on the point group is extracted not only from the point group on a cross section illustrated in FIG. 5 but also from the plurality of unit models arranged to extend in the depth direction (bead formation direction) of FIG. 5.

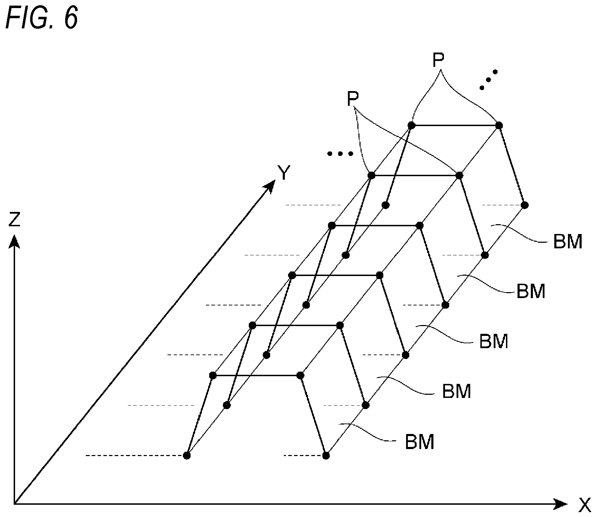

FIG. 6 is a diagram illustrating one row of unit models extending in the depth direction. The above-described unit models BM have been described in a cross-sectional shape in a zx plane, and an actual unit model BM is, for example, a hexahedron having eight vertices in total when a cross-sectional shape is a trapezoid. In this manner, a plurality of points of a three-dimensional unit model BM are extracted as information on a point group.

The above-described point group may be points other than the vertices of the unit model BM.

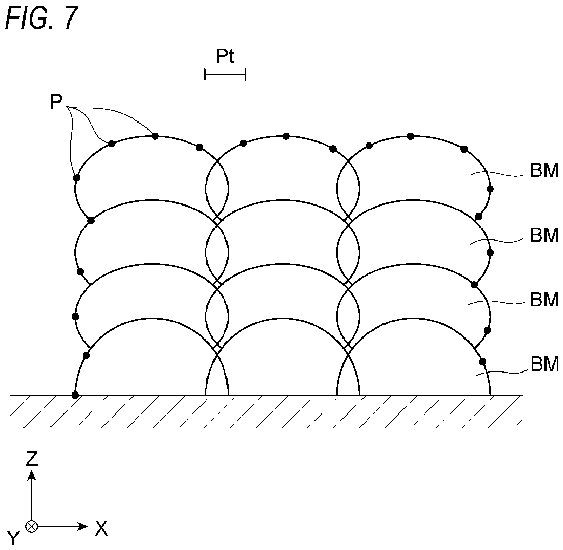

FIG. 7 is a diagram illustrating a state in which a shape of a manufactured object is reproduced by elliptical unit models. When the unit models reproduce a deposited shape with a smooth curve such as an ellipse, an aggregate of points P obtained by sampling an outer surface shape of the unit models at predetermined intervals (pitches Pt) may be defined as the above-described point group. The information on the point group is not limited to an orthogonal coordinate system (x, y, z), and may be converted into a preferred coordinate system such as (r, θ, z) including a pole coordinate system. In this case, as described above, the points P obtained by sampling the outer surface shape of the unit models at the predetermined intervals are also obtained in the depth direction, and are defined as a point group.

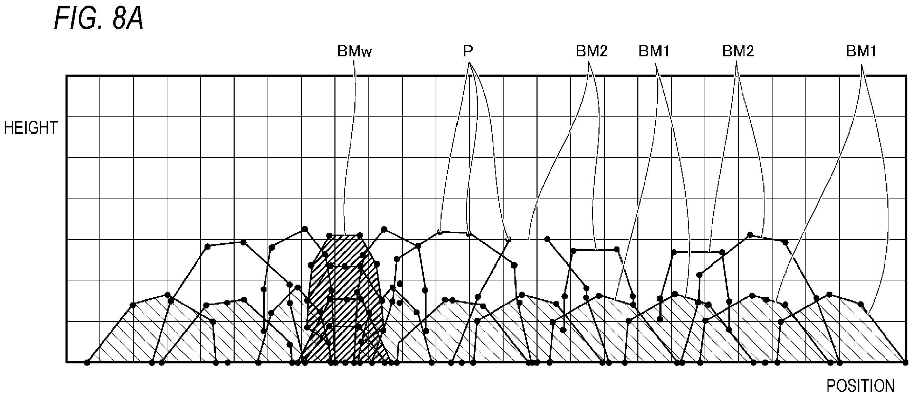

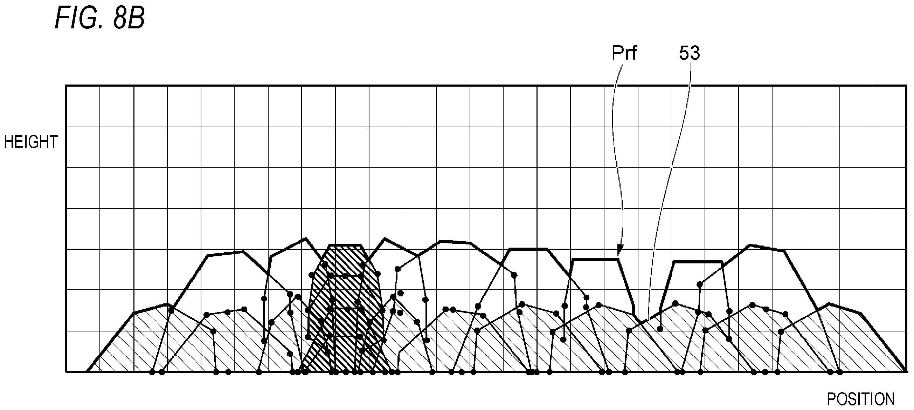

FIGS. 8A and 8B are diagrams illustrating a state in which the profile Prf is extracted from a plurality of unit models approximate to the shape of the manufactured object. The manufactured object exemplified here includes a frame-shaped wall portion and a filling portion that fills a region surrounded by the wall portion. FIGS. 8A and 8B show a cross section of a part of the model.

FIG. 8A illustrates a four-layer unit model BMw constituting the wall portion, and two-layer unit models BM1 and BM2 constituting the filling portion in which a bead width and a bead height are set to be larger than those of the wall portion at a side of the unit model BMw. The unit model BM1 is a model on the first layer, and the unit model BM2 is a model on the second layer. Each of the unit models BMw, BM1, and BM2 has a shape based on a trapezoid, and it is assumed that beads are formed in the filling portion in order from a side closest to the unit model BMw serving as the wall portion.

The deposited shape of the manufactured object illustrated in FIG. 8A can be set as the profile Prf of outer surfaces of the unit models on the outermost layer illustrated in FIG. 8B. As illustrated in FIG. 6, the profile Prf is a three-dimensional profile that is also connected in the depth direction of FIG. 8B, and represents a height distribution on an xy plane.

Next, the information on the point group obtained as described above is converted into a contour diagram representing the shape of the manufactured object (S4). Specifically, image information (contour diagram) in which the unevenness on a surface of the manufactured object with respect to a plane in a specific direction is expressed in a contour form is generated. The processing of generating the information on the three-dimensional point group based on the information on the profile Prf and converting the information into the contour diagram is performed by the image information conversion unit 35 illustrated in FIG. 2.

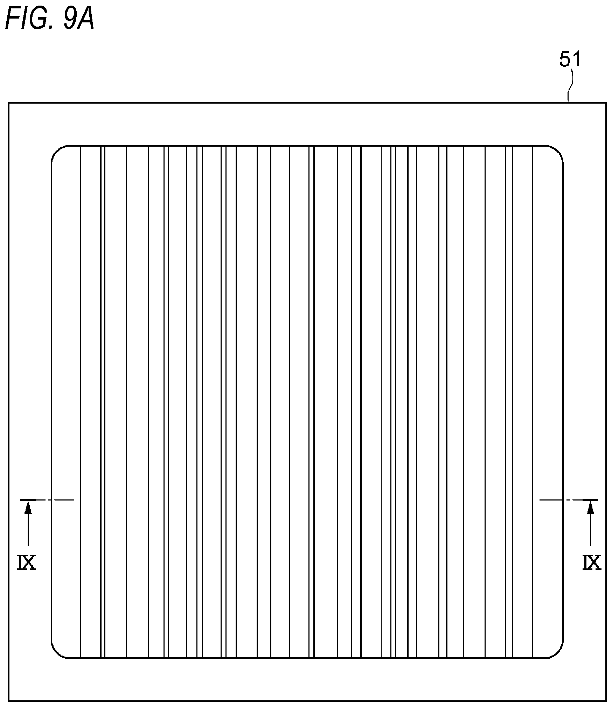

FIG. 9A is a schematic diagram of an image based on image information expressed in a contour form.

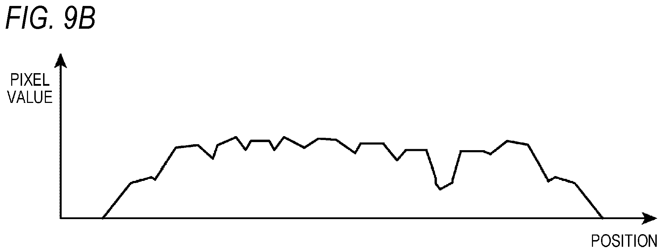

FIG. 9B is a graph illustrating pixel values on a line IX-IX in FIG. 9A. An image 51 represents height information as pixel values (shading) on a two-dimensional plane, and the pixel values which are the height information in FIG. 9B represent height distribution of the profile Prf illustrated in FIG. 8B.

The worker can visually and easily grasp a state of the unevenness of the point group information which is less likely to be intuitively understood by observing the image 51 on the display unit 240 such as a monitor illustrated in FIG. 2. In addition, an amount of information to be stored can be reduced by converting the point group information into the image information. Further, if an image processing technique such as binarization processing is applied, desired feature information can be easily extracted.

The pixel value of the image information to be displayed as a contour may be an additive height z, a difference between a planned height z₀ according to the additive plan and the additive height z obtained by modeling, a height difference in a specific minute unit section, or the like. That is, the pixel value of the image information may be a value representing a degree of inclination due to the unevenness in addition to an absolute value of a height formed by the unevenness of the surface shape. When the pixel value of the image information is set to the difference between the planned height z₀ and the additive height z, the pixel value is suitable information for specifying an excessively or insufficiently weld region of the welding bead. Further, an inclination angle of the unevenness with respect to a specific axial direction may be set to a value to be displayed as a contour. For example, as in the profile Prf in FIG. 8B, if the above-described inclination angle is defined as an inclination from a vertical direction (z-axis direction), an inclined portion is highlighted. Therefore, a degree of flatness of a built surface is likely to be evaluated, and when a large concave portion 53 is present, the large concave portion 53 is likely to be found.

In FIG. 9A, a height in the z-axis direction with respect to the xy plane is displayed in contour form, and is not limited thereto, and other values may be displayed, for example, a value in an x-direction with respect to the yz plane may be displayed in contour form.

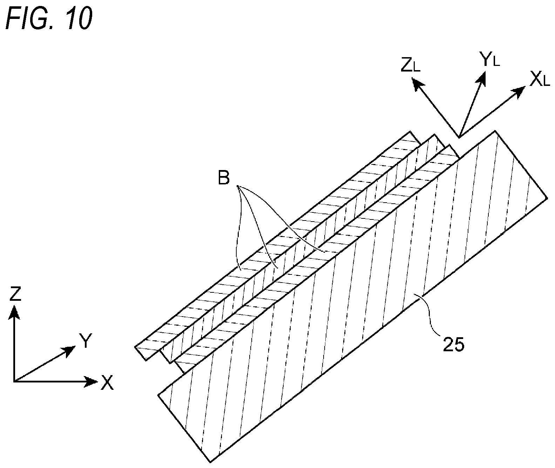

FIG. 10 is a diagram illustrating a case in which the welding beads B are built on the inclined base 25. When a manufactured object is additively manufactured, the base 25 may be inclined from a horizontal plane (xy plane), and the welding beads B may be formed on the inclined base plane and then deposited. In this case, it is preferred that the above-described object to be displayed in a contour form is not the height z of the coordinate system (x, y, z), but a value of a zL axis in a local coordinate system (xL, yL, zL) in which the inclined base plane is an xL-yL plane and a normal direction of the base plane is a zL direction. Accordingly, it is easy to grasp a change in shape due to the additive height of the welding bead of the manufactured object.

Next, a narrow portion of the welding beads is extracted from the obtained contour diagram (S5). The narrow portion extraction unit 37 of the image information generating device 220 illustrated in FIG. 2 extracts, from the image information converted by the image information conversion unit 35, the narrow portion generated between the welding beads formed based on the additive plan (between the unit models BM or between the rows of the unit models). The narrow portion extraction unit 37 outputs information on a position, a size, and the like of the extracted narrow portion to the feature calculation unit 39. The feature calculation unit 39 calculates the feature of the narrow portion from the input information on the narrow portion, based on coordinate information on the narrow portion and coordinate information on the periphery of the narrow portion.

The narrow portion extraction unit 37 extracts a narrow portion by performing appropriate image processing on the input image information. For example, a narrow portion with a sharp recess may be extracted by binarization processing or the like. Specifically, a recessed region extracted by subjecting the image of the image information to binarization processing using a specific pixel value as a threshold value is captured as a narrow portion. In addition, a reference mask representing a specific concave shape may be prepared, a portion having a high degree of similarity to the concave shape may be obtained by mask processing, or a bottom position may be obtained by applying a gradient descent method to the image information, and the extraction method is not particularly limited. The feature calculation unit 39 calculates various features such as a size and a center position of the narrow portion extracted by the narrow portion extraction unit 37. In addition, an outer surface shape in the vicinity of the narrow portion may be obtained as a feature of the narrow portion.

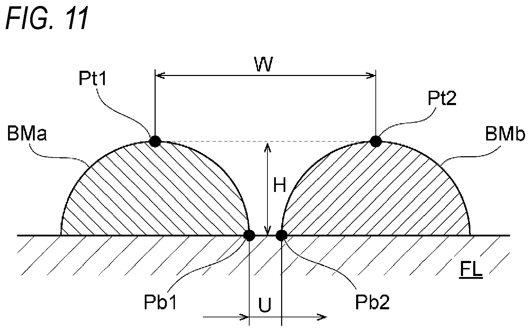

FIG. 11 is a diagram illustrating an example of features of the narrow portion. As schematically illustrated in FIG. 11, it is assumed that a pair of adjacent welding beads are formed on a base surface FL representing a surface of the base 25 or existing welding beads (not illustrated) on a lower layer, and a narrow portion is formed between the pair of welding beads. In this case, in a direction orthogonal to the bead formation direction (the left-right direction in FIG. 11), an interval between model lower end portions Pb₁ and Pb₂ at a bottom of a valley portion formed by a pair of models BMa and BMb representing the welding beads is defined as a bottom interval U, and an interval between a top portion Pt₁ of one model BMa and a top portion Pt₂ of the other model BMb is defined as a bead interval W. The bottom interval U may be an interval in a longitudinal direction between the pair of models BMa and BMb (interval in a direction from the start to the end of the bead formation). An average value of a height from the base surface FL to the top portion Pt₁ of the model BMa and a height from the base surface FL to the top portion Pt₂ of the model BMb is defined as an average height H. The average height H corresponds to a valley depth of the valley portion formed by the pair of models BMa and BMb in an additive direction. The bottom interval U, the bead interval W, and the average height H can be used as the features of the narrow portion.

The U, W, and H may be calculated by preparing a model function simulating the shape of the narrow portion in advance and fitting the model function to the shape of the narrow portion. For example, a specific reference profile function that can be approximated to the shape of the narrow portion of the profile Prf may be selected using the above-described profile Prf, and a feature corresponding to a parameter value of the function may be set by fitting the selected reference profile function. The reference profile function may be, for example, a quadratic curve, a hyperbola, a Gaussian curve, a circular arc having a specific curvature radius, and a V-shaped line having a specific angle.

Next, the occurrence of a defect or a defect size is predicted based on information on the feature of the narrow portion calculated as described above and the additive conditions of the welding beads forming the narrow portion (S6). The additive condition acquisition unit 210 illustrated in FIG. 2 obtains the additive conditions of the welding beads forming the narrow portion extracted by the narrow portion extraction unit 37 with reference to the additive plan. The obtained information on the additive conditions and the information on the feature of the narrow portion output from the feature calculation unit 39 are input to the defect determination unit 250.

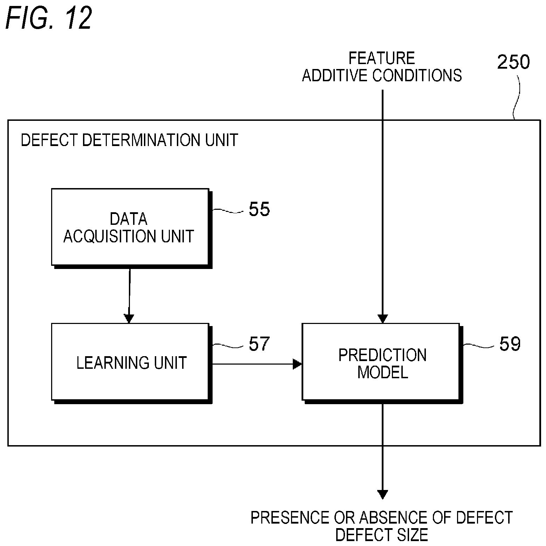

FIG. 12 is a functional block diagram of the defect determination unit 250 provided in the defect predicting device 200. The defect determination unit 250 determines whether a defect occurs in the narrow portion based on the input information on the additive conditions and the feature of the narrow portion. In addition, when a defect occurs, the defect size may be predicted.

Here, the defect size means a size including a cross-sectional area or a length of a cross section orthogonal to the longitudinal direction of the welding beads. Specific examples of the defect size include indexes such as a diameter (equivalent circle diameter) when a shape of the defect is approximated to a true circle, a cross-sectional area of the approximated circle, an area of the defect to be observed, and a long axis length and a short axis length of an ellipse when the shape of the defect is approximated to an ellipse.

The defect determination unit 250 may predict a defect by using a prediction model that is generated by machine-learning a relation between the information on the additive conditions and the narrow portion, and the presence or absence of a defect or the defect size in advance. In this case, the defect determination unit 250 includes a data acquisition unit 55 and a learning unit 57, and the learning unit 57 repeatedly learns various learning data acquired from the data acquisition unit 55 to generate a prediction model 59. Examples of the means of generating the prediction model 59 by the learning unit 67 include well-known means such as a decision tree, linear regression, random forest, support vector machine, Gaussian process regression, and neural network. The generated prediction model 59 outputs information on the presence or absence of a defect or the defect size when the information on the additive conditions and the feature of the narrow portion is input.

In addition to the machine learning, the defect determination unit 250 may simply compare a penetration depth corresponding to the additive conditions with a depth of the narrow portion, and determine that a defect occurs when the difference is larger than a predetermined threshold value. In this manner, various methods can be adopted as a defect predicting method.

Next, a verification result will be described in which a plurality of rows of welding beads are formed, a narrow portion is formed in some of the welding beads, and a defect of the narrow portion is predicted.

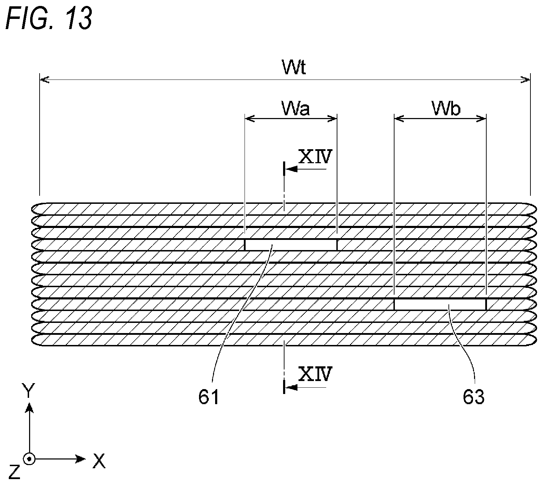

FIG. 13 is a model diagram illustrating contents of the additive plan for the manufactured object formed by the plurality of welding beads. The manufactured object is formed by adjacently arranging a plurality of welding beads parallel to one another along one direction (x direction) on the xy plane. Some of the plurality of welding beads are provided with cavities 61 and 63 having widths Wa and Wb within the entire length Wt as defects.

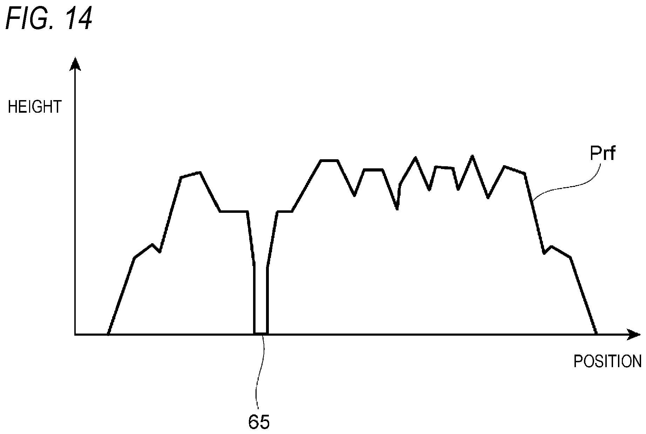

FIG. 14 is a graph illustrating a height distribution of the model in a cross section taken along a line XIV-XIV in FIG. 13. The profile Prf shown here represents the height information of the point group extracted from the model illustrated in FIG. 13. It can be seen that the profile Prf has a narrow portion 65 corresponding to the cavity 61.

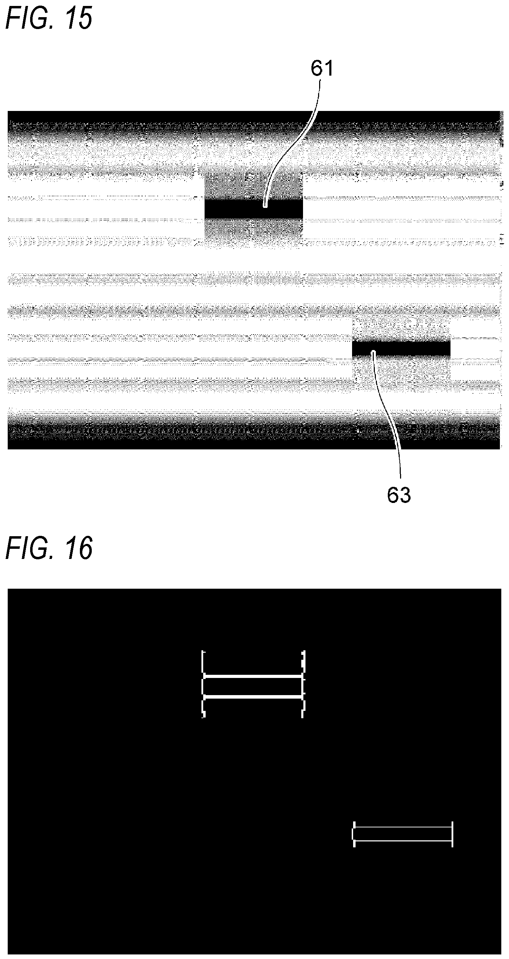

FIG. 15 is an image illustrating results of imaging information on the point group extracted from the model diagram of FIG. 13. The cavities 61 and 63 illustrated in FIG. 13 clearly appear in the image, and it can be seen from the pixel values that a height of the surrounding models is affected.

FIG. 16 is an image illustrating results of processing the image illustrated in FIG. 15 to highlight the narrow portions. The image is obtained by subjecting the image illustrated in FIG. 15 to image processing such as binarization processing and differentiation processing, thereby highlighting narrow portions having particularly steep slopes. It can be seen from the image in FIG. 16 that the cavity 61 has a larger pixel value and a wider range than those of the cavity 63.

Then, the feature of the narrow portion is extracted from the image in FIG. 16, and the defect is predicted using the trained prediction model. As a result, it can be predicted that a defect size of the cavity 61 is 1.73 mm and a defect size of the cavity 63 is 0.73 mm. A measurement dimension of an actual defect (cavity) was 1.77 mm for the cavity 61 and 0.55 mm for the cavity 63. Therefore, according to the present method, it can be verified that the presence or absence of a defect and the defect size can be predicted with sufficient accuracy.

As described above, even if the manufactured object has a three-dimensional complicated shape that is less likely to be grasped, the image information that can be easily grasped for each layer to be additively manufactured can be obtained by modeling the shape into the information on the point group. By performing appropriate image processing on the image information, it is possible to visually and easily grasp the information on the distribution of the unevenness, the excess or shortage of the additive height, and the like. Accordingly, the degree of flatness of the deposited surface is likely to be evaluated, and the defect state and the defect positions such as an underfill portion and an excessive weld portion in additive manufacturing are likely to be specified. Therefore, it is possible to easily correct the additive plan to an appropriate additive plan by feeding back to the additive plan so as not to cause a defect.

In addition, the defect information is extracted through the image processing, and thus for example, the defect information can be simply obtained with high accuracy as compared with a case in which the defect is directly specified by applying the model shape of the narrow portion from a measured value of the shape or the information on the point group obtained from the model. Then, by using the prediction model in which the relation between the feature and the additive conditions of the narrow portion and the defect is obtained, it is possible to predict the occurrence of a defect and the size of the defect to be generated at a planning stage before the building, and to easily review the additive plan. That is, it is possible to simulate the occurrence of a defect and to analytically determine the quality of the additive plan without actual building. In addition, by obtaining the prediction model subjected to machine learning, it is possible to reliably predict a defect even if the details of the mechanism of defect occurrence cannot be grasped.

The present invention is not limited to the above-described embodiments, and combinations of the respective configurations of the embodiments and changes and applications made by those skilled in the art based on the description of the specification and well-known techniques are also intended for the present invention and are included in the scope of protection.

As described above, the present specification discloses the following matters.
(1) An image information generating device that generates image information representing a shape of a manufactured object obtained by depositing layers each made of a plurality of welding beads, the image information generating device including:
   a coordinate information acquisition unit configured to approximate a design shape of each layer of the manufactured object using a model simulating a shape of the welding bead and acquire coordinate information on a plurality of points of the approximated model;
   a profile extraction unit configured to obtain a profile representing a surface shape of the specified layer based on the coordinate information; and
   an image information conversion unit configured to convert a concave-convex shape of a surface of the specified layer into image information using the profile.
   According to the image information generating device, the design shape of the manufactured object is approximated by the model simulating the bead shape, the profile representing the surface shape of the model is obtained, and the concave-convex shape of the surface of the manufactured object is converted into the image information using the profile. Accordingly, the surface shape of each layer can be confirmed based on the image information even in a manufactured object having a complicated three-dimensional shape, and thus it is easy to visually grasp a distribution of unevenness, excess or shortage of an additive height, and the like.
(2) The image information generating device according to (1), in which the image information includes difference information between an additive height of the specified layer and a planned height of the layer.
   According to the image information generating device, it is possible to more easily specify a portion at which an underfill is generated in additive manufacturing, a portion at which excess or shortage of the welding beads occurs, and the like.
(3) The image information generating device according to (1), in which the image information includes information indicating a gradient distribution formed by the unevenness of the surface shape.
   According to the image information generating device, a degree of flatness of the surface shape of the manufactured object is likely to be evaluated.
(4) An image processing device including:
   a narrow portion extraction unit configured to extract a concave narrow portion formed by the welding beads through image processing from the image information generated by the image information generating device according to any one of (1) to (3); and
   a feature calculation unit configured to calculate a feature including any one of a position and a size of the extracted narrow portion.
   According to the image processing device, the feature is calculated by extracting the narrow portion through the image processing, and thus the processing can be more simply performed with higher accuracy than, for example, a method for specifying a narrow portion by applying a model shape of the narrow portion.
(5) A defect predicting device including:
   the image information generating device according to any one of (1) to (3);
   a narrow portion extraction unit configured to extract a concave narrow portion formed by the welding beads through image processing from the image information generated by the image information generating device;
   a feature calculation unit configured to calculate a feature including any one of a position and a size of the extracted narrow portion;
   an additive condition acquisition unit configured to acquire an additive condition of the welding beads that form the narrow portion; and
   a defect determination unit configured to predict presence or absence of a defect occurring in the narrow portion in the manufactured object or a size of the defect according to the feature of the narrow portion and the additive condition of the narrow portion.
   According to the defect predicting device, the feature is calculated by extracting the narrow portion through the image processing, and thus the feature can be simply obtained with high accuracy. In addition, by predicting the defect according to the feature and the additive condition, the defect can be predicted in a design stage before the building, and the additive plan can be reviewed.
(6) The defect predicting device according to (5), in which
   the defect determination unit predicts the presence or absence of the defect or the size of the defect according to the feature of the narrow portion calculated by the feature calculation unit and the additive condition acquired by the additive condition acquisition unit based on a prediction model obtained by machine-learning a relation between the feature and the additive condition of the narrow portion, and the presence or absence of the defect or the size of the defect.
   According to the defect predicting device, by using the prediction model subjected to machine learning, a defect can be predicted even if the details of a mechanism of defect occurrence cannot be grasped.
(7) An image information generating method for generating image information representing a shape of a manufactured object obtained by depositing layers each made of a plurality of welding beads, the image information generating method including:
   approximating a design shape of each layer of the manufactured object using a model simulating a shape of the welding bead and acquiring coordinate information on a plurality of points of the approximated model;
   obtaining a profile representing a surface shape of the specified layer based on the coordinate information; and
   converting a concave-convex shape of a surface of the specified layer into image information using the profile.
(8) An image processing method including:
   extracting a concave narrow portion formed by the welding beads through image processing from the image information generated by using the image information generating method according to (7); and
   calculating a feature including any one of a position and a size of the extracted narrow portion.
(9) A defect predicting method including:
   extracting a concave narrow portion formed by the welding beads through image processing from the image information generated by using the image information generating method according to (7);
   calculating a feature including any one of a position and a size of the extracted narrow portion;
   acquiring an additive condition of the welding beads that form the narrow portion; and
   predicting presence or absence of a defect occurring in the narrow portion in the manufactured object or a size of the defect according to the feature of the narrow portion and the additive condition of the narrow portion.
(10) A program for executing a procedure for generating image information representing a shape of a manufactured object obtained by depositing layers each made of a plurality of welding beads, the program causing a computer to execute:
   a procedure of approximating a design shape of each layer of the manufactured object using a model simulating a shape of the welding bead and acquiring coordinate information on a plurality of points of the approximated model;
   a procedure of obtaining a profile representing a surface shape of the specified layer based on the coordinate information; and
   a procedure of converting a concave-convex shape of a surface of the specified layer into image information using the profile.
(11) A program causing a computer to execute:
   a procedure of extracting a concave narrow portion formed by the welding beads through image processing from the image information generated by the program according to (10); and
   a procedure of calculating a feature including any one of a position and a size of the extracted narrow portion.
(12) A program causing a computer to execute:
   a procedure of extracting a concave narrow portion formed by the welding beads through image processing from the image information generated by the program according to (10);
   a procedure of calculating a feature including any one of a position and a size of the extracted narrow portion;
   a procedure of acquiring an additive condition of the welding beads that form the narrow portion; and
   a procedure of predicting presence or absence of a defect occurring in the narrow portion in the manufactured object or a size of the defect according to the feature of the narrow portion and the additive condition of the narrow portion.

The present application is based on Japanese Patent Application No. 2022-115682 filed on July 20, 2022, the contents of which are incorporated herein by reference.

### REFERENCE SIGNS LIST

11: manufacturing unit
13: control device
15: manipulator
17: manipulator control unit
19: filler metal supply unit
19a: reel
19b: feeding mechanism
21: heat source control unit
23: welding torch
25: base
31: coordinate information acquisition unit
33: profile extraction unit
35: image information conversion unit
37: narrow portion extraction unit
39: feature calculation unit
51: image
53: concave portion
55: data acquisition unit
57: learning unit
59: prediction model
61, 63: cavity
65: narrow portion
100: additive manufacturing device
200: defect predicting device
210: additive condition acquisition unit
220: image information generating device
230: image processing device
240: display unit
250: defect determination unit
B: welding bead
BM, BM1, BM2: unit model
BMa, BMb: model
FL: base surface
H: average height
M: filler metal
P: point
Prf: profile
Pb₁, Pb₂: model lower end portion
Pt: pitch
Pt1, Pt2: top portion
U: bottom interval
W: bead interval
Wa, Wb: width
Wk: manufactured object
Wt: total length

## Claims

1. An image information generating device that generates image information representing a shape of a manufactured object obtained by depositing layers each made of a plurality of welding beads, the image information generating device comprising:
a coordinate information acquisition unit configured to approximate a design shape of each layer of the manufactured object using a model simulating a shape of the welding bead and acquire coordinate information on a plurality of points of the approximated model;
a profile extraction unit configured to obtain a profile representing a surface shape of the specified layer based on the coordinate information; and
an image information conversion unit configured to convert a concave-convex shape of a surface of the specified layer into image information using the profile.

2. The image information generating device according to claim 1, wherein
the image information includes difference information between an additive height of the specified layer and a planned height of the layer.

3. The image information generating device according to claim 1, wherein
the image information includes information indicating a gradient distribution formed by the unevenness of the surface shape.

4. An image processing device comprising:
a narrow portion extraction unit configured to extract a concave narrow portion formed by the welding beads through image processing from the image information generated by the image information generating device according to any one of claims 1 to 3; and
a feature calculation unit configured to calculate a feature including any one of a position and a size of the extracted narrow portion.

5. A defect predicting device comprising:
the image information generating device according to any one of claims 1 to 3;
a narrow portion extraction unit configured to extract a concave narrow portion formed by the welding beads through image processing from the image information generated by the image information generating device;
a feature calculation unit configured to calculate a feature including any one of a position and a size of the extracted narrow portion;
an additive condition acquisition unit configured to acquire an additive condition of the welding beads that form the narrow portion; and
a defect determination unit configured to predict presence or absence of a defect occurring in the narrow portion in the manufactured object or a size of the defect according to the feature of the narrow portion and the additive condition of the narrow portion.

6. The defect predicting device according to claim 5, wherein
the defect determination unit predicts the presence or absence of the defect or the size of the defect according to the feature of the narrow portion calculated by the feature calculation unit and the additive condition acquired by the additive condition acquisition unit based on a prediction model obtained by machine-learning a relation between the feature and the additive condition of the narrow portion, and the presence or absence of the defect or the size of the defect.

7. An image information generating method for generating image information representing a shape of a manufactured object obtained by depositing layers each made of a plurality of welding beads, the image information generating method comprising:
approximating a design shape of each layer of the manufactured object using a model simulating a shape of the welding bead and acquiring coordinate information on a plurality of points of the approximated model;
obtaining a profile representing a surface shape of the specified layer based on the coordinate information; and
converting a concave-convex shape of a surface of the specified layer into image information using the profile.

8. An image processing method comprising:
extracting a concave narrow portion formed by the welding beads through image processing from the image information generated by using the image information generating method according to claim 7; and
calculating a feature including any one of a position and a size of the extracted narrow portion.

9. A defect predicting method comprising:
extracting a concave narrow portion formed by the welding beads through image processing from the image information generated by using the image information generating method according to claim 7;
calculating a feature including any one of a position and a size of the extracted narrow portion;
acquiring an additive condition of the welding beads that form the narrow portion; and
predicting presence or absence of a defect occurring in the narrow portion in the manufactured object or a size of the defect according to the feature of the narrow portion and the additive condition of the narrow portion.

10. A program for executing a procedure for generating image information representing a shape of a manufactured object obtained by depositing layers each made of a plurality of welding beads, the program causing a computer to execute:
a procedure of approximating a design shape of each layer of the manufactured object using a model simulating a shape of the welding bead and acquiring coordinate information on a plurality of points of the approximated model;
a procedure of obtaining a profile representing a surface shape of the specified layer based on the coordinate information; and
a procedure of converting a concave-convex shape of a surface of the specified layer into image information using the profile.

11. A program causing a computer to execute:
a procedure of extracting a concave narrow portion formed by the welding beads through image processing from the image information generated by the program according to claim 10; and
a procedure of calculating a feature including any one of a position and a size of the extracted narrow portion.

12. A program causing a computer to execute:
a procedure of extracting a concave narrow portion formed by the welding beads through image processing from the image information generated by the program according to claim 10;
a procedure of calculating a feature including any one of a position and a size of the extracted narrow portion;
a procedure of acquiring an additive condition of the welding beads that form the narrow portion; and
a procedure of predicting presence or absence of a defect occurring in the narrow portion in the manufactured object or a size of the defect according to the feature of the narrow portion and the additive condition of the narrow portion.
